# DEMANDE DE BREVET EUROPEEN

(11) **EP 1 503 389 A1**
(43) Date de publication de la demande: **02.02.2005**
(21) Numéro de dépôt: 04103692.2
(22) Date de dépôt: 30.07.2004
(51) Int. Cl.: H01F 21/12, H01H 1/00, H01L 23/64

(54) **Inductance commutable**

(30) Priorité: 01.08.2003 FR 0309576
(71) Demandeur: ST MICROELECTRONICS S.A., 92120 Montrouge (FR)
(72) Inventeur: ANCEY, Pascal, 38420, REVEL (FR); SAIAS, Daniel, 75005, PARIS (FR)
(74) Mandataire: de Beaumont, Michel

(57) **Abrégé**

L'invention concerne une inductance commutable, réalisable dans un circuit intégré, comprenant : une spire (s1 ; s"1) interrompue entre deux premiers points (4/5 ; 40/41) reliés à deux bornes (E2/E3 ; E5/E6) par l'intermédiaire de deux métallisations (6/7 ; 42/43) passant l'une au-dessus de l'autre, l'une des deux métallisations étant déformable ; un évidement entre les deux métallisations ; et un dispositif de commutation (C) apte à déformer la métallisation déformable pour écarter ou mettre en contact les deux dites métallisations.

## Description

La présente invention concerne le domaine des inductances et plus particulièrement des inductances de valeurs variables, ces inductances étant réalisées à partir de pistes conductrices formées par exemple dans des niveaux de métallisation de circuits intégrés.

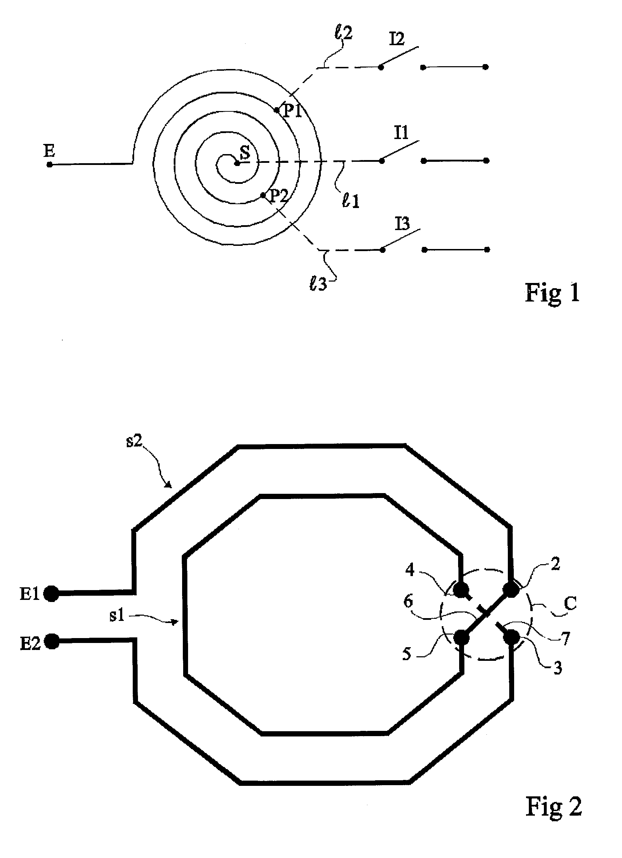

La figure 1 est un schéma d'une inductance comprenant une bobine spirale à prises intermédiaires. Une telle bobine est de façon classique réalisée sur un niveau de métal d'un circuit intégré. La bobine comprend quatre spires entre une borne extérieure E et une borne intérieure S. La borne S est reliée à un interrupteur I1 par l'intermédiaire d'une ligne l1 représentée en pointillés et réalisée sur un niveau de métal différent du niveau de métal utilisé pour former la bobine. Des points intermédiaires P1 et P2, situés dans cet exemple au niveau de la deuxième et de la troisième spire de la bobine, sont respectivement reliés à des interrupteurs I2 et I3 par l'intermédiaire de lignes l2 et l3 réalisées sur un niveau différent de celui de la bobine. La borne E de la bobine et les bornes des interrupteurs I1 à I3 non reliées à la bobine sont connectées à des bornes de connexion et éventuellement à des éléments du circuit intégré sur lequel est formée la bobine.

Un inconvénient de cette inductance est que la présence de lignes l1 à l3 entre la bobine et les interrupteurs entraîne des effets parasites dans la bobine.

Un autre inconvénient de cette inductance est que quand on choisit d'activer l'interrupteur I2 ou I3, l'extrémité non utilisée de la bobine située au-delà du point P1 ou du point P2 entraîne des effets parasites dans la partie "utile" de la bobine située entre le point E et le point P1 ou le point P2.

En conséquence, une telle inductance n'est pas adaptée à la réalisation de plusieurs valeurs d'inductances en raison de phénomènes parasites.

Un objet de la présente invention est de prévoir une inductance capable de présenter plusieurs valeurs d'inductance avec peu de phénomènes parasites.

Pour atteindre cet objet, la présente invention prévoit une inductance commutable, réalisable dans un circuit intégré, comprenant : une spire interrompue entre deux premiers points reliés à deux bornes par l'intermédiaire de deux métallisations passant l'une au-dessus de l'autre, l'une des deux métallisations étant déformable ; un évidement entre les deux métallisations ; et un dispositif de commutation apte à déformer la métallisation déformable pour écarter ou mettre en contact les deux dites métallisations.

Selon un mode de réalisation de l'inductance susmentionnée le dispositif de commutation comprend : une cavité formée dans un substrat ; une poutre conductrice en suspension au-dessus de la cavité, la poutre conductrice étant la métallisation déformable ; une bande conductrice placée au fond de la cavité, la bande conductrice étant l'autre desdites métallisations ; et des moyens de déformation de la poutre aptes à mettre en contact la poutre et la bande conductrice.

Selon un mode de réalisation de l'inductance susmentionnée, les moyens de déformation de la poutre comprennent des blocs multicouches placés sur la poutre, chaque bloc comprenant une couche conductrice placée entre une couche isolante et une couche d'un matériau ayant un coefficient de dilatation différent de celui de la poutre, des moyens d'activation étant aptes à faire passer un courant dans la couche conductrice de chaque bloc pour chauffer la poutre et ladite couche de matériau de chaque bloc.

Selon un mode de réalisation de l'inductance susmentionnée, l'inductance comprend une seconde spire, la seconde spire étant interrompue entre deux deuxièmes points connectés auxdites bornes, la spire externe étant interrompue et reliée à des bornes de connexion.

Selon un mode de réalisation de l'inductance susmentionnée, l'inductance comprend des spires supplémentaires dont chacune est associée à une autre spire par des métallisations croisées dont l'une est déformable et est associée à un des dispositifs de commutation.

Cet objet, ces caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 décrite précédemment, est une vue de dessus schématique d'une inductance comportant une bobine spirale à prises intermédiaires selon l'art antérieur ;
la figure 2 est une vue de dessus schématique d'une inductance commutable selon un mode de réalisation de la présente invention ;
la figure 3 est une vue de dessus schématique d'une inductance commutable selon un autre mode de réalisation de la présente invention ;
la figure 4 est une vue de dessus schématique d'une inductance commutable selon un autre mode de réalisation de l'invention ;
la figure 5 est une vue en coupe d'un exemple de dispositif de commutation utilisé dans une inductance selon la présente invention, le dispositif de commutation étant à l'état "inactif" ;
la figure 6 est une vue de dessus du dispositif représenté en figure 5 ; et
la figure 7 est une vue en coupe du dispositif des figures 5 et 6 à l'état "actif".

La figure 2 est une vue de dessus schématique d'une inductance commutable selon la présente invention. Cette inductance comprend deux spires concentriques, une spire intérieure s1 et une spire extérieure s2. Les spires s1 et s2 sont formées dans un même niveau de métallisation. La spire extérieure s2 est interrompue dans une première région entre deux points connectés à des bornes E1 et E2, de connexion de l'inductance. Les spires intérieure s1 et extérieure s2 sont interrompues dans une deuxième région, dite de commutation. Dans cette deuxième région, la spire extérieure s2 est interrompue entre des points 2 et 3 et la spire intérieure s1 entre des points 4 et 5. Les points 2 et 5 sont reliés par une métallisation 6 formée dans le même niveau de métal que les spires intérieure s1 et extérieure s2. Les points 3 et 4 sont reliés par une métallisation 7 passant en dessus ou en dessous de la métallisation 6. Un évidement est formé entre les métallisations 6 et 7. La métallisation 7 est déformable de sorte que, quand un dispositif de commutation C représenté en pointillés et placé dans la région de commutation est actif, les métallisations 6 et 7 sont en contact.

Quand le dispositif de commutation C est inactif et que les métallisations 6 et 7 sont écartées l'une de l'autre, l'inductance est une inductance à deux spires et le courant circule entre les bornes E1 et E2 en passant par une première partie de la spire extérieure s2, par la métallisation 6, par la spire intérieure s1, par la métallisation 7 et par une deuxième partie de la spire extérieure s2.

Quand le dispositif de commutation C est actif, les métallisations 6 et 7 sont reliées et seule la spire extérieure s2 est active, la spire intérieure s1 étant court-circuitée.

Ainsi, selon que le dispositif de commutation C est actif ou inactif, l'inductance selon la présente invention est une inductance à une spire ou une inductance à deux spires.

On notera que la région de commutation peut être disposée à tout emplacement choisi de la périphérie des spires. Par exemple, elle peut se trouver près de l'une des entrées E1 ou E2 ou, comme cela est représenté, à l'opposé de ces entrées.

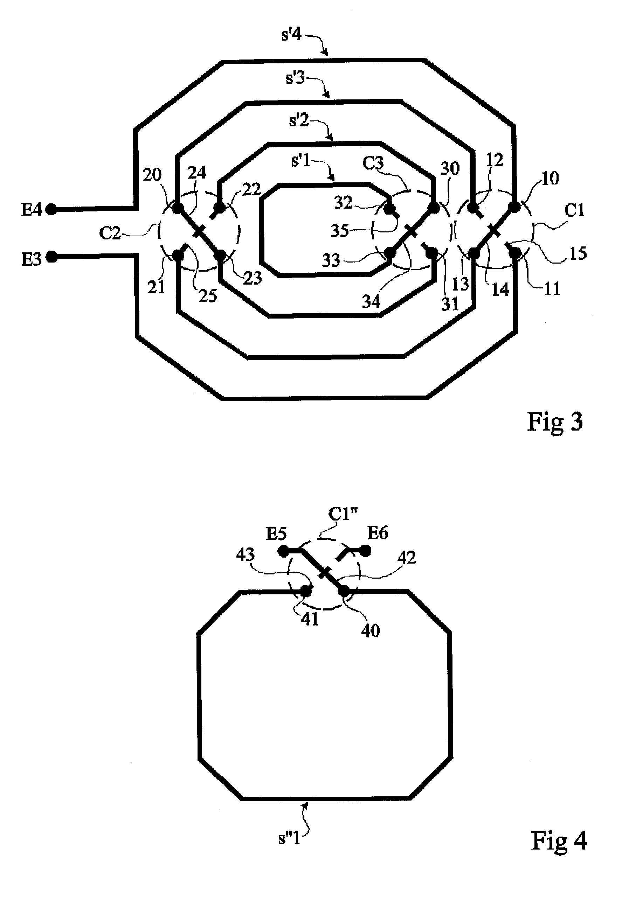

La figure 3 est une vue de dessus schématique d'une inductance selon un autre mode de réalisation de la présente invention. Cette inductance comprend quatre spires concentriques s'1, s'2, s'3 et s'4, la spire s'1 étant la spire intérieure et la spire s'4 la spire extérieure. Les spires s'1 à s'4 sont formées dans un même niveau de métallisation. La spire s'4 est interrompue entre deux points connectés à des bornes E3 et E4 de connexion de l'inductance. Les spires les plus extérieures s'4 et s'3 sont toutes deux interrompues dans une première région de commutation associée à un dispositif de commutation C1. Dans cette première région de commutation, la spire s'4 est interrompue entre des points 10 et 11 et la spire s'3 entre des points 12 et 13. Les points 10 et 13 sont reliés par une métallisation 14 formée dans le même niveau de métal que l'ensemble des spires s'1 à s'4. Les points 11 et 12 sont reliés par une métallisation 15 passant en dessus ou en dessous de la métallisation 14. Un évidement est formé entre les métallisations 14 et 15. La métallisation 15 est déformable de sorte que quand le dispositif de commutation C1 est actif, les métallisations 14 et 15 sont en contact.

Les spires s'3 et s'2 sont interrompues dans une deuxième région dite de commutation associée à un dispositif de commutation C2. Dans cette deuxième région, la spire s'3 est interrompue entre des points 20 et 21 et la spire s'2 entre des points 22 et 23. Les points 20 et 23 sont reliés par une métallisation 24 formée dans le même niveau de métal que l'ensemble des spires. Les points 21 et 22 sont reliés par une métallisation 25 passant en dessus ou en dessous de la métallisation 24. Un évidement est formé entre les métallisations 24 et 25. La métallisation 25 est déformable de sorte que, quand le dispositif de commutation C2 est actif, les métallisations 24 et 25 sont en contact.

Les spires s'2 et s'1 sont interrompues dans une troisième région dite de commutation associée à un dispositif de commutation C3. Dans cette troisième région, la spire s'2 est interrompue entre des points 30 et 31 et la spire s'1 entre des points 32 et 33. Les points 30 et 33 sont reliés par une métallisation 34 formée dans le même niveau de métal que l'ensemble des spires. Les points 31 et 32 sont reliés par une métallisation 35 passant en dessus ou en dessous de la métallisation 34. Un évidement est formé entre les métallisations 34 et 35. La métallisation 35 est déformable de sorte que, quand le dispositif de commutation C3 est actif, les métallisations 34 et 35 sont en contact.

Quand les dispositifs de commutation C1, C2 et C3 sont inactifs et que les métallisations 14/15, 24/25, et 34/35 sont écartées l'une de l'autre, l'inductance est une inductance à quatre spires et le courant circule entre les bornes E3 et E4 en passant par une première partie de la spire s'4, la métallisation 14, une première partie de la spire s'3, la métallisation 25, une première partie de la spire s'2, la métallisation 34, la spire s'1, la métallisation 35, la seconde partie de la spire s'2, la métallisation 24, la seconde partie de la spire s'3, la métallisation 15 et enfin la seconde partie de la spire s'4.

Quand le dispositif de commutation C1 est actif, les métallisations 14 et 15 sont reliées. Les spires s'1 à s'3 sont court-circuitées. Seule la spire s'4 est active et l'inductance est une inductance à une spire.

Quand le dispositif de commutation C2 est actif et que le dispositif de commutation C1 est inactif, les métallisations 24 et 25 sont reliées et les métallisations 14 et 15 sont écartées. Les spires s'1 et s'2 sont court-circuitées. Les spires s'3 et s'4 sont actives et l'inductance est une inductance à deux spires.

Quand le dispositif de commutation C3 est actif et que les dispositifs de commutation C1 et C2 sont inactifs, les métallisations 34 et 35 sont reliées et les métallisations 14/15 et 24/25 sont écartées. La spire s'1 est court-circuitée. Les autres spires s'2, s'3 et s'4 sont actives et l'inductance est une inductance à trois spires.

La figure 4 est une vue de dessus schématique d'une inductance selon un autre mode de réalisation de la présente invention. Cette inductance comprend une seule spire s"1. La spire s"1 est interrompue entre deux points 40 et 41 dans une région de commutation associée à un dispositif de commutation C1". Le point 40 est relié à une borne E5 par l'intermédiaire d'une métallisation 42 formée sur le même niveau de métal que celui utilisé pour la spire s"1. Le point 41 est relié à une borne E6 par l'intermédiaire d'une métallisation 43 passant pardessus ou par-dessous la métallisation 42. Un évidement est formé entre les métallisations 42 et 43. La métallisation 43 est déformable de sorte que, quand le dispositif de commutation C1" est actif, les métallisations 42 et 43 sont en contact.

Quand le dispositif de commutation C1" est actif, la spire s"1 est court-circuitée. Les bornes E5 et E6 sont connectées l'une à l'autre. L'inductance vue entre les bornes E5 et E6 est sensiblement nulle. Quand le dispositif de commutation C1" est inactif, l'inductance est une inductance à une spire.

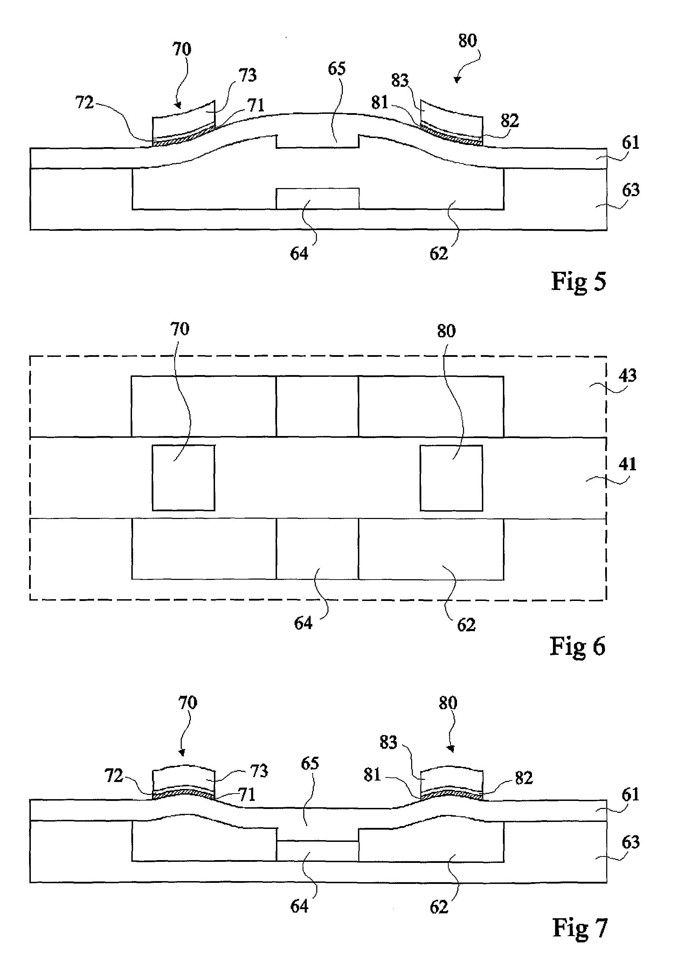

Les figures 5, 6 et 7 représentent un dispositif de commutation pouvant être utilisé dans une inductance selon la présente invention. Les figures 5 et 7 sont des vues en coupe du dispositif de commutation et la figure 6 est une vue de dessus. Une poutre conductrice 61 est en suspension au-dessus d'une cavité 62 formée dans un substrat 63. Une bande 64 d'un matériau conducteur est placée au fond de la cavité 62. La bande conductrice 64 est placée sensiblement perpendiculairement à la poutre 61, comme cela est représenté en figure 6. Un plot conducteur 65 est placé sous la poutre 61 au-dessus de la bande conductrice 64. Dans une inductance selon la présente invention, la bande 64 et la poutre conductrice 61 correspondent par exemple aux métallisations 6 et 7 de la figure 2.

Le dispositif de commutation comprend des moyens pour déformer la poutre 61 afin de mettre en contact le plot conducteur 65 et la bande 64. Quand le dispositif de commutation est à l'état inactif, comme cela est représenté en figure 5, la portion de la poutre 61 située au-dessus de la cavité 62 est dans cet exemple légèrement bombée vers le haut. Le plot conducteur 65 est éloigné de la bande conductrice 64. Quand le dispositif de commutation est à l'état actif, comme cela est représenté en figure 7, la poutre 61 est déformée de sorte que le plot conducteur 5 est en contact avec la bande conductrice 4.

Les moyens utilisés pour déformer la poutre sont par exemple des moyens agissant par effet bilame. Ainsi, dans cet exemple deux blocs multicouches 70 et 80 sont placés au-dessus de la portion de la poutre 61 située au-dessus de la cavité 62 de part et d'autre du plot conducteur 65. Chaque bloc comprend une couche isolante 71, 81 posée sur la poutre 61. Les couches isolantes 71, 81 sont recouvertes de couches conductrices 72, 82. Les couches conductrices 72, 82 sont recouvertes de couches 73 et 83 d'un matériau ayant un coefficient de dilatation différent de celui de la poutre 61.

Pour passer de l'état inactif à l'état actif, tel qu'illustré respectivement en figures 5 et 7, un circuit d'activation, non représenté fait passer du courant dans les couches conductrices 72 et 82, ce qui a pour effet de chauffer les couches 73, 83 et la poutre 61. Les couches 73 et 83 ayant dans cet exemple un coefficient de dilatation supérieur à celui de la poutre 61, les couches 73 et 83 s'allongent davantage que la poutre 61. En conséquence, les portions de la poutre 61 situées près des parois de la cavité 62 se bombent légèrement vers le haut et la partie centrale de la poutre 61 se creuse vers le bas.

La poutre conductrice 61, le plot conducteur 65 et la bande conductrice 64 sont constitués d'un matériau conducteur tel que de l'aluminium ou du cuivre. De plus, afin d'établir un bon contact entre la bande conductrice 64 et le plot conducteur 65, ils seront de préférence réalisés au moins en partie avec un matériau non oxydable tel que de l'or.

Le substrat 63 pourra être une couche isolante. Dans un premier exemple de configuration, le substrat 63 est la couche isolante séparant le dernier et l'avant dernier niveau de connexion du réseau d'interconnexions d'un circuit intégré. La bande conductrice 64 peut être formée sur l'avant dernier niveau de connexions et la poutre conductrice 61 formée sur le dernier niveau de connexions. La ligne inductive d'un dispositif selon la présente invention est alors réalisée sur le dernier ou l'avant dernier niveau de connexions. Dans un autre exemple de configuration, la couche isolante est formée au-dessus du dernier niveau de connexions du réseau d'interconnexions d'un circuit intégré. La bande conductrice est formée sur le dernier niveau de connexions. La ligne inductive d'un dispositif selon la présente invention est alors réalisée dans sa majorité sur le dernier niveau de connexions.

Les couches isolantes 71, 81 peuvent être constituées d'oxyde de silicium ou d'un matériau isolant tels que ceux couramment utilisés pour former les couches isolantes entre les niveaux de connexions du réseau d'interconnexions.

Les couches conductrices 72 et 82 sont par exemple constituées de titane.

Les couches 73 et 83 sont constituées d'un matériau présentant un coefficient de dilatation thermique élevé, en général une couche métallique.

Selon une variante de réalisation du dispositif de commutation tel que décrit précédemment, la poutre conductrice 61 pourra être entourée d'une couche isolante dans laquelle sont formées les couches 71 et 81 des blocs 70 et 80.

Selon une autre variante de réalisation du dispositif de commutation, la poutre conductrice 61 est remplacée par une poutre d'un matériau isolant tel que du nitrure de silicium SiN dans laquelle ou sous laquelle est formée une ligne conductrice par exemple en cuivre ou en aluminium qui est reliée au plot conducteur 65. La ligne conductrice correspond à une métallisation du dispositif de l'invention permettant de relier deux spires. Le dispositif de déformation de la poutre par effet bilame comprend deux résistances chauffantes sous forme de deux couches conductrices par exemple en nitrure placées dans la poutre. Des blocs d'un matériau tel que de l'aluminium ayant un coefficient de dilation thermique différent du matériau isolant de la poutre sont placés sur, sous ou autour de la poutre à proximité des résistances chauffantes.

Bien entendu, la présente invention est susceptible de diverses variantes et modifications qui apparaîtront à l'homme de l'art. En particulier, l'homme de l'art saura prévoir d'autres dispositifs de commutation. De plus, dans les dispositifs de commutation décrits ci-dessus, on pourra prévoir de maintenir la déformation de la poutre lorsque le dispositif de commutation est actif, en utilisant des moyens consommant une énergie moins élevée que celle consommée par le passage du courant dans les couches conductrices 72 et 84. Pour ce faire, on peut placer des électrodes sous la poutre 61 et des électrodes au fond de la cavité 62 en regard les unes des autres. Une fois la poutre déformée sous l'action de l'effet bilame, il est possible de maintenir la déformation par attraction électrostatique en appliquant une tension entre les électrodes.

## Revendications

1. Inductance commutable, réalisable dans un circuit intégré, comprenant :
une spire (s1 ; s"1) interrompue entre deux premiers points (4/5 ; 40/41) reliés à deux bornes (E1/E2 ; E5/E6) par l'intermédiaire de deux métallisations (6/7 ; 42/43) passant l'une au-dessus de l'autre, l'une des deux métallisations étant déformable ;
un évidement entre les deux métallisations ; et
un dispositif de commutation (C) apte à déformer la métallisation déformable pour écarter ou mettre en contact les deux dites métallisations.

2. Inductance selon la revendication 1, dans laquelle le dispositif de commutation comprend :
une cavité (62) formée dans un substrat (63) ;
une poutre conductrice (61) en suspension au-dessus de la cavité, la poutre conductrice étant la métallisation déformable ;
une bande conductrice (64) placée au fond de la cavité, la bande conductrice étant l'autre desdites métallisations ; et
des moyens (70, 80) de déformation de la poutre aptes à mettre en contact la poutre et la bande conductrice.

3. Inductance selon la revendication 2, dans laquelle les moyens de déformation de la poutre comprennent des blocs multicouches (70, 80) placés sur la poutre (61), chaque bloc comprenant une couche conductrice (72, 82) placée entre une couche isolante (71, 81) et une couche d'un matériau (73, 83) ayant un coefficient de dilatation différent de celui de la poutre, des moyens d'activation étant aptes à faire passer un courant dans la couche conductrice de chaque bloc pour chauffer la poutre et ladite couche de matériau de chaque bloc.

4. Inductance selon la revendication 1, comprenant une seconde spire (s2), la seconde spire étant interrompue entre deux deuxièmes points (2, 3) connectés auxdites bornes (2, 3), la spire externe étant interrompue et reliée à des bornes de connexion (E1, E2).

5. Inductance selon la revendication 4, comprenant des spires supplémentaires (s'3, s'4) dont chacune est associée à une autre spire par des métallisations croisées dont l'une est déformable et est associée à un des dispositifs de commutation.
